# EUROPÄISCHE PATENTSCHRIFT

(11) **EP 3 123 534 B1**
(45) Veröffentlichungstag und Bekanntmachung des Hinweises auf die Patenterteilung: **12.09.2018**
(21) Anmeldenummer: 15720589.9
(22) Anmeldetag: 23.03.2015
(51) Int. Cl.: H01L 41/047, H01L 41/09, H02N 2/00, H02N 2/02, H02N 2/10

(54) **ULTRASCHALLMOTOR**
ULTRASONIC MOTOR
MOTEUR ULTRASONIQUE

(30) Priorität: 26.03.2014 DE 102014205577
(43) Veröffentlichungstag der Anmeldung: 01.02.2017
(73) Patentinhaber: Physik Instrumente (PI) GmbH & Co. KG, 76228 Karlsruhe (DE)
(72) Erfinder: WISCHNEWSKIY, Wladimir, 14712 Rathenow (DE); WISCHNEWSKI, Alexej, 76744 Wörth (DE)
(74) Vertreter: Grünecker Patent- und Rechtsanwälte PartG mbB
(86) Internationale Anmeldenummer: PCT/DE2015/100120
(87) Internationale Veröffentlichungsnummer: WO 2015/144135

(56) Entgegenhaltungen:
- US-A1- 2010 019 621
- US-A1- 2013 257 222

## Beschreibung

Die Erfindung betrifft einen Ultraschallmotor nach den Ansprüchen 1 bis 10.

Die Druckschriften US 5,714,833, US 6,979,934B1 und US 6,806,620B1 beschreiben Ultraschallmotoren mit als Wellenleiter-Resonator wirkenden Ultraschallaktoren in Form einer piezoelektrischen polarisierten Platte, in der die Richtung des entsprechenden Polarisationsvektors senkrecht zur Schwingungsebene der im Ultraschallaktor erzeugten akustischen Biege-Stehwelle verläuft. In den Ultraschallaktoren dieser Motoren wird zur Erzeugung der Biege-Stehwelle, aber auch zur Erzeugung von Längsdeformationen, der Piezomodul d31 genutzt. In modernen piezokeramischen Werkstoffen erreicht der Wert des Piezomoduls d31 üblicherweise -200pm/V. Dadurch ist die maximal mögliche Bewegungsgeschwindigkeit eines durch den Ultraschallaktor angetriebenen Elements begrenzt; ebenso begrenzt ist die vom Ultraschallmotor entwickelte maximal mögliche Kraft. US 2010 019 621 A1 beschreibt einen Aktuator mit schräg zu dessen Längserstreckung angeordneten interdigitalen Elektroden.

Vor diesem Hintergrund ist es Aufgabe der Erfindung, einen Ultraschallmotor mit hoher Bewegungsgeschwindigkeit und mit hoher Kraft bereitzustellen.

Die Lösung dieser Aufgabe erfolgt durch einen Ultraschallmotor gemäß Anspruch 1, wobei die sich daran anschließenden Unteransprüche mindestens zweckmäßige Ausgestaltungen und Weiterbildungen umfassen.

Demnach wird von einem Ultraschallmotor ausgegangen, der einen Wellenleiter-Resonator in Form eines Ultraschallaktors aus einem polarisierten piezoelektrischen Material, und zumindest ein an dem Ultraschallaktor angeordnetes Friktionselement, und ein durch das Friktionselement angetriebenes Element und eine elektrische Erregervorrichtung umfasst. Der Ultraschallaktor hat die Form bzw. Geometrie einer Platte, vorzugsweise einer rechteckigen Platte, mit einer Länge L, welche die größte Ausdehnung der Platte in entsprechender (Längen-)Richtung beschreibt, einer Höhe H, und einer Dicke T, welche die geringste Ausdehnung der Platte in entsprechender (Dicken-)Richtung beschreibt. Die Platte weist zwei flächenmäßig größte und parallel zueinander angeordnete Hauptflächen, zwei längere Seitenflächen und zwei kürzeren Seitenflächen auf, wobei die kürzeren Seitenflächen Stirnflächen bilden. Die Dicke T entspricht hierbei dem Abstand zwischen den beiden Hauptflächen. Der Ultraschallaktor weist weiterhin Generatoren für akustische Ultraschallstehwellen auf, welche jeweils aus dem polarisierten piezoelektrischen Material und zumindest einer daran angeordneten Erregerelektrode und wenigstens einer daran angeordneten allgemeinen Elektrode gebildet sind. Der Ultraschallaktor ist in Richtung seiner Länge L in drei Generatorabschnitte unterteilt, wobei der zentrale und mittig angeordnete Generatorabschnitt einen ersten Generator zur Erzeugung einer akustischen Längs-Stehwelle aufweist und die beiden peripheren Generatorabschnitte, die beidseitig an den zentralen Generatorabschnitt angrenzen, jeweils einen zweiten Generator zur Erzeugung einer akustischen Biege-Stehwelle aufweisen. Zumindest die beiden zweiten Generatoren umfassen Erregerelektroden und allgemeine Elektroden in Form dünner Streifen (streifenförmige Elektroden), die auf den beiden Hauptflächen des Ultraschallaktors in abwechselnder Reihenfolge und in Längenrichtung gesehen jeweils beabstandet und parallel zueinander angeordnet sind, wobei die streifenförmigen Elektroden in Richtung der Höhe H des Ultraschallaktors bzw. von einer langen Seitenfläche zur anderen langen Seitenfläche des Ultraschallaktors verlaufen. Beabstandet im Sinne der Erfindung bedeutet hierbei einen positiven, von Null unterschiedlichen Abstand. Das piezoelektrische Material der zweiten Generatoren ist derart polarisiert, dass die Polarisationsvektoren parallel zur Schwingungsebene der akustischen Biege-Stehwelle ausgerichtet sind. Hierdurch ist für die Erzeugung der akustischen Biege-Stehwelle der d33-Piezomodul nutzbar.

Mit solch einem Ultraschallmotor ist es möglich, zur Erzeugung der Biegedeformationen statt des normalerweise genutzten Piezomoduls d31 den wesentlich größeren Piezomodul d33 zu verwenden. Im Vergleich zu den aus dem Stand der Technik bekannten Ultraschallmotoren ist es dadurch möglich, die maximale Bewegungsgeschwindigkeit des anzutreibenden Elements und die maximale durch die Motoren entwickelte Kraft um das 2 bis 2,5-fache zu erhöhen, oder umgekehrt die elektrische Erregerspannung um das 2 bis 2,5-fache zu verringern. Dies erhöht den Wirkungsgrad und erweitert die Einsatzmöglichkeiten für solche Ultraschallmotoren.

Es kann von Vorteil sein, dass die Polarisationsvektoren des piezokeramischen Materials des ersten Generators ebenfalls parallel zur Schwingungsebene der akustischen Biege-Stehwelle ausgerichtet sind, und die in einem Winkel zu den Polarisationsvektoren des piezokeramischen Materials der zweiten Generatoren verlaufen.

Es kann auch von Vorteil sein, dass der erste Generator Erregerelektroden und allgemeine Elektroden in Form dünner Streifen umfasst, die auf den beiden Hauptflächen des Ultraschallaktors in abwechselnder Reihenfolge und jeweils beabstandet und parallel zueinander angeordnet sind.

Ebenso kann es von Vorteil sein, dass das Verhältnis von Länge L zu Höhe H des Ultraschallaktors so gewählt ist, dass im Aktor die erste Mode der akustischen Längs-Stehwelle und die dritte Mode der akustischen Biege-Stehwelle anregbar sind, und dass insbesondere L > 3 H ist.

Zudem kann es von Vorteil sein, dass das Verhältnis Länge L zu Dicke T des Ultraschallaktors so gewählt ist, dass L gleich der halben Wellenlänge (λ/2) der in dem Ultraschallaktor erzeugten akustischen Längs-Stehwelle und L gleich der anderthalbfachen Wellenlänge (3λ/2) der akustischen Biege-Stehwelle gleicher Frequenz fo entspricht.

Weiterhin kann es von Vorteil sein, dass die Breite der streifenförmigen Erregerelektroden und der streifenförmigen allgemeinen Elektroden kleiner oder gleich 0,1 mm ist.

Darüber hinaus kann es von Vorteil sein, dass der Abstand zwischen benachbarten streifenförmigen Elektroden kleiner oder gleich T/2 ist.

Außerdem kann es von Vorteil sein, dass das Friktionselement auf einer der beiden Stirnflächen des Ultraschallaktors angeordnet ist und elastisch an eine Friktionsoberfläche des anzutreibenden Elements angepresst ist.

Es kann auch von Vorteil sein, dass der Ultraschallaktor des Ultraschallmotors zwei Friktionselemente aufweist, wovon ein Friktionselement an einer Stirnfläche des Ultraschallaktors angeordnet ist, und ein Friktionselement an der anderen Stirnfläche des Ultraschallaktors angeordnet ist, und beide Friktionselemente elastisch an Friktionsoberflächen des anzutreibenden Elements angepresst sind.

Ferner kann es von Vorteil sein, dass der Ultraschallmotor zwei oder mehr Ultraschallaktoren umfasst, wobei zwischen zwei benachbarten Ultraschallaktoren eine schalldämmende Schicht vorgesehen ist.

Es zeigen in schematischer und nicht maßstäblicher Weise:
Fig. 1: Explosionsdarstellung einer Ausführungsform des erfindungsgemäßen Ultraschallmotors
Fig. 2: Explosionsdarstellung einer weiteren Ausführungsform des erfindungsgemäßen Ultraschallmotors
Fig. 3: Darstellung 13: Ultraschallaktor eines erfindungsgemäßen Ultraschallmotors in Vorderansicht; Darstellung 14: Ultraschallaktor gemäß Darstellung 13 in Rückansicht.
Fig. 4: Darstellung 25: Vorderansicht eines Ultraschallaktors eines erfindungsgemäßen Ultraschallmotors; Darstellung 26: Draufsicht auf den Ultraschallaktor gemäß Darstellung 25; Darstellung 27: Rückansicht des Ultraschallaktors gemäß Darstellung 25; Darstellung 60: Elektrische Erregervorrichtung und Schaltungsanordnung zur elektrischen Ansteuerung des Ultraschallaktors gemäß den Darstellungen 25 bis 27
Fig. 5: Darstellung 35: Vorderansicht eines Ultraschallaktors eines erfindungsgemäßen Ultraschallmotors; Darstellung 36: Draufsicht auf den Ultraschallaktor gemäß Darstellung 35; Darstellung 37: Rückansicht des Ultraschallaktors gemäß Darstellung 35; Darstellung 62: Elektrische Erregervorrichtung und Schaltungsanordnung zur elektrischen Ansteuerung des Ultraschallaktors gemäß Darstellung 35
Fig. 6: Darstellung 38: Dehn-Deformation des Ultraschallaktors eines erfindungsgemäßen Ultraschallmotors bei Anregung der ersten Mode einer akustischen Längs-Stehwelle in diesem; Darstellung 39: Stauch-Deformation des Ultraschallaktors eines erfindungsgemäßen Ultraschallmotors bei Anregung der ersten Mode einer akustischen Längs-Stehwelle in diesem
Fig. 7: Darstellungen 40 und 42: Biege-Deformationen des Ultraschallaktors eines erfindungsgemäßen Ultraschallmotors bei Anregung der dritten Mode einer akustischen Biege-Stehwelle in diesem
Fig. 8: Ultraschallaktor eines erfindungsgemäßen Ultraschallmotors mit Darstellung der Polarisationsvektoren in unterschiedlichen Abschnitten
Fig. 9: Darstellung möglicher Bewegungsbahnen eines Punktes des an einem Ultraschallaktor eines erfindungsgemäßen Ultraschallmotors angeordneten Friktionselements bei einer Schaltungsanordnung gemäß Fig. 4 oder Fig. 5
Fig. 10: Schaltungsanordnung zur elektrischen Ansteuerung des Ultraschallaktors gemäß Fig. 5
Fig. 11: Schaltungsanordnung zur elektrischen Ansteuerung des Ultraschallaktors eines erfindungsgemäßen Ultraschallmotors
Fig. 12: Darstellung möglicher Bewegungsbahnen eines Punktes des an einem Ultraschallaktor eines erfindungsgemäßen Ultraschallmotors angeordneten Friktionselements bei einer Schaltungsanordnung gemäß Fig. 10
Fig. 13: Darstellung 52: Vorderansicht eines Ultraschallaktors eines erfindungsgemäßen Ultraschallmotors; Darstellung 53: Draufsicht von oben auf den Ultraschallaktor gemäß Darstellung 52; Darstellung 54: Rückansicht des Ultraschallaktors gemäß Darstellung 52; Darstellung 55: Draufsicht von unten auf den Ultraschallaktor gemäß Darstellung 52
Fig. 14: Explosionsdarstellung einer Ausführungsform des erfindungsgemäßen Ultraschallmotors mit mehreren Ultraschallaktoren
Fig. 15: Perspektivische Ansicht einer weiteren Ausführungsform des erfindungsgemäßen Ultraschallmotors mit mehreren Ultraschallaktoren

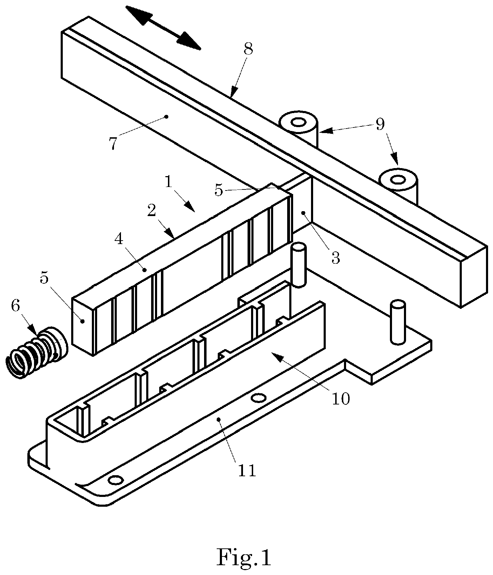

Fig. 1 zeigt in Explosionsdarstellung eine Ausführungsform des erfindungsgemäßen Ultraschallmotors als Linearantrieb. Dieser umfasst einen Ultraschallaktor 1 als Wellenleiter-Resonator 2, wobei der Ultraschallaktor als rechteckige Platte 4 mit zwei flächenmäßig größten und parallel zueinander angeordneten Hauptflächen, zwei längeren und parallel zueinander angeordneten Seitenflächen und zwei kürzeren und parallel zueinander angeordneten Seitenflächen, welche Stirnflächen 5 ausbilden, ausgeführt ist. Der Ultraschallmotor umfasst zudem ein über Lagerelemente in Form von Rollenlagern 9 beweglich gelagertes anzutreibendes Element 8 in Form eines Stabes, an dem eine Friktionsfläche 7 angeordnet ist. An der dem anzutreibenden Element zugewandten Stirnfläche 5 des Ultraschallaktors ist ein Friktionselement 3 angeordnet, dass sich in mechanischem bzw. Friktions-Kontakt mit der Friktionsfläche 7 befindet. Der Ultraschallaktor ist hierzu über ein federndes Element 6 elastisch in Richtung des anzutreibenden Elements gedrückt. Die Halteeinheit 10 des Gehäuses 11 dient der Halterung bzw. Lagerung des Ultraschallaktors.

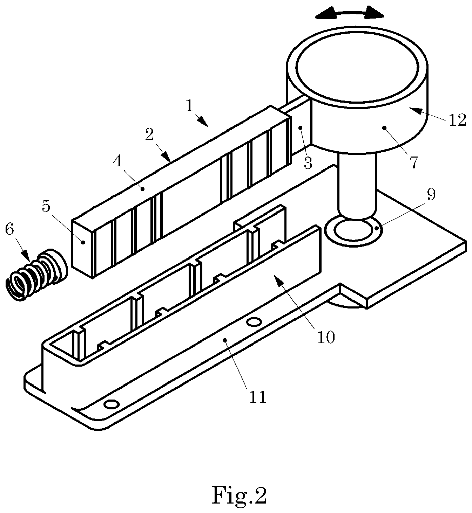

Fig. 2 zeigt in Explosionsdarstellung eine weitere Ausführungsform des erfindungsgemäßen Ultraschallmotors als Rotationsantrieb. Der Aufbau ist hierbei weitgehend identisch zu dem Aufbau des linearen Ultraschallmotors gemäß Fig. 1, weshalb im Folgenden nur die Unterschiede beschrieben werden. Im Gegensatz zum Ultraschallmotor gemäß Fig. 1 ist das anzutreibende Element rotationssymmetrisch in Form einer Scheibe 12 mit einer daran angeordneten Friktionsschicht 7. An der Scheibe 12 befindet sich ein Zapfen, welcher mittels eines Kugellagers 9, welches in das Gehäuse 11 eingesetzt ist, rotatorisch beweglich gelagert ist.

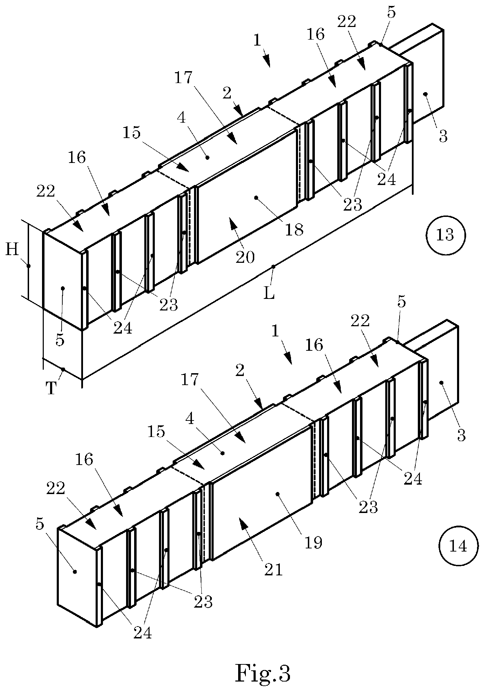

Fig. 3 zeigt in den Darstellungen 13 und 14 den Ultraschallaktor der Ultraschallmotoren gemäß Fig. 1 und 2 in Vorderansicht und in Rückansicht. Der Ultraschallaktor in Form einer Platte weist als größte Ausdehnung in entsprechender Richtung die Länge L auf. Senkrecht zur Länge L bzw. zur Längserstreckung des Ultraschallaktors weist dieser die Höhe H auf. Als kleinste Ausdehnung in entsprechender Richtung weist der Ultraschallaktor die Dicke T auf, wobei die Dicke T auch bestimmt ist durch den Abstand der beiden Hauptflächen 20 und 21. Das Verhältnis L zur Dicke T ist dabei so gewählt, dass die Länge L gleich der halben Wellenlänge (λ/2) der in der Platte erzeugten akustischen Längs-Stehwelle (entspricht der 1. Mode) und gleich der anderthalbfachen Wellenlänge (3λ /2) der akustischen Biege-Stehwelle (entspricht der 3. Mode) gleicher Frequenz fo ist.

Für die Piezokeramik PIC 181 der Firma PI Ceramic beträgt das Verhältnis L/T etwa 9,65. Die Höhe H kann sich im Bereich von L/3 > H > T bewegen.

Der Ultraschallaktor weist in Längsrichtung gesehen drei etwa gleich große Abschnitte bzw. Teile auf. An den hierbei zentralen Abschnitt 15 grenzen beidseitig die peripheren Abschnitte 16 an. Der zentrale Abschnitt 15 umfasst den ersten Generator 17 für eine akustische Längs-Stehwelle, welcher eine flächige Erregerelektrode 18, die an einer der beiden Hauptflächen des Ultraschallaktors angeordnet ist, eine flächige allgemeine Elektrode 19, die an der entsprechend gegenüberliegenden Hauptfläche des Ultraschallaktors angeordnet ist, und das zwischen diesen beiden Elektroden befindliche polarisierte piezoelektrische Material in Form von Piezokeramik.

Jeder der beiden peripheren Abschnitte oder Teile 16 umfasst einen zweiten Generator 22 für eine akustische Biege-Stehwelle, welcher schmale, streifenförmige Erregerelektroden 23 und schmale, streifenförmige allgemeine Elektroden 24, die jeweils an den beiden Hauptflächen des Ultraschallaktors angeordnet sind, aufweist. Hierbei verlaufen die streifenförmigen Elektroden in Richtung der Höhe H, und zwar parallel und in Längenrichtung gesehen beabstandet zueinander, wobei sich Erregerelektroden und allgemeine Elektroden abwechseln. Im konkreten Ausführungsbeispiel gemäß Fig. 3 sind bei jedem zweiten Generator insgesamt acht streifenförmige Elektroden angeordnet, und zwar auf jeder Hauptfläche zwei streifenförmige Erregerelektroden 23 und zwei allgemeine Elektroden 24. Die allgemeinen Elektroden 24 sind hierbei einerseits am peripheren Ende des Ultraschallaktors angeordnet, wobei sie an die Stirnflächen 5 angrenzen, und andererseits am jeweils gegenüberliegenden Endabschnitt des zweiten Generators angeordnet, wobei sie von der Erregerelektrode 18 und der allgemeinen Elektrode 19 des ersten Generators beabstandet sind. Die Anordnung der streifenförmigen Elektroden ist auf den beiden gegenüberliegenden Hauptflächen im Wesentlichen gleich, jedoch ist auch denkbar, dass die streifenförmigen Elektroden auf einer Hauptfläche in Längsrichtung gesehen versetzt zu den streifenförmigen Elektroden auf der anderen Hauptfläche angeordnet sind.

Der Abstand zwischen zwei benachbarten streifenförmigen Elektroden ist kleiner oder gleich T/2. Die Länge der streifenförmigen Elektroden ist so bemessen, dass sie mit beiden Enden bis an die längeren Seitenflächen des Ultraschallaktors reichen. Es ist jedoch ebenso denkbar, dass die streifenförmigen Elektroden kürzer ausgeführt sind, und nur mit einem Ende oder mit keinem der Enden bis an die längeren Seitenflächen des Ultraschallaktors reichen und dementsprechend von diesen beabstandet sind.

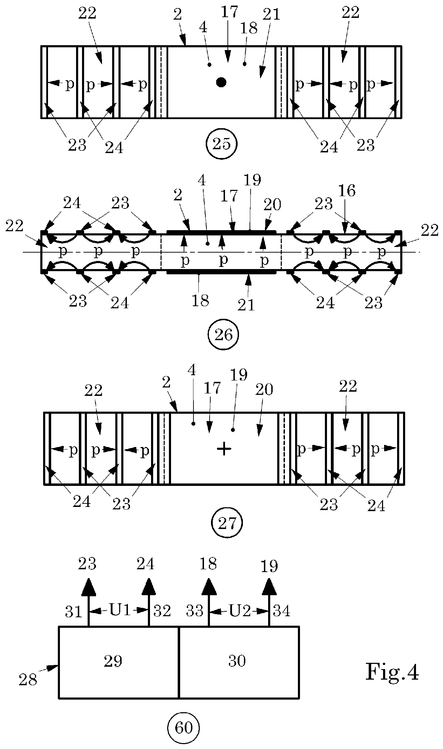

Die Darstellungen 25 bis 27 von Fig. 4 verdeutlichen anhand unterschiedlicher Ansichten die Polarisation des piezoelektrischen Materials des Ultraschallaktors gemäß den Figuren 1 bis 3. Darstellung 25 zeigt dabei den Ultraschallaktor in Vorderansicht, d.h. mit Blick auf eine der beiden Hauptflächen. Die Polarisationsvektoren (gekennzeichnet durch Pfeile mit Index p) des piezoelektrischen Materials im Bereich der zweiten Generatoren 22 weisen von den allgemeinen Elektroden 24 in Richtung der Erregerelektroden 23. In Darstellung 26, einer Draufsicht auf den Ultraschallaktor bzw. auf eine seiner längeren Seitenfläche, ist zu erkennen, dass die Polarisationsvektoren in einem Bogen von den allgemeinen Elektroden 24 in Richtung der Erregerelektroden 23 weisen, wobei der Pfeil mit dem Index p hier die Gesamtheit der einzelnen geraden Polarisationsvektoren verkörpert. Die einzelnen geraden Polarisationsvektoren ändern dabei, ausgehend von den allgemeinen Elektroden, stetig ihre Richtung. Demgegenüber verlaufen die Polarisationsvektoren des piezoelektrischen Materials im Bereich des ersten Generators 17 in gleichbleibender Richtung von der Erregerelektrode 18 zur allgemeinen Elektrode 19. Darstellung 27 von Fig. 4 zeigt die Rückansicht des Ultraschallaktors gemäß den Darstellungen 25 und 26.

Darstellung 60 von Fig. 4 zeigt eine elektrische Erregervorrichtung 28 und eine Schaltungsanordnung zur elektrischen Ansteuerung des Ultraschallaktors gemäß den Darstellungen 25 bis 27. Die elektrische Erregervorrichtung 28 ist hierbei zweiphasig ausgeführt, und weist zwei elektrische Generatoren 29 und 30 auf, die an ihren Anschlüssen 31 und 32 bzw. 33 und 34 die elektrischen Wechselspannungen U1 und U2 bereitstellen, die zueinander um den Winkel φ phasenverschoben sind.

Die Spannungen U1 und U2 besitzen die gleiche oder annähernd gleiche Frequenz fo, bei der im Wellenleiter-Resonator 2 die erste Mode der akustischen Längs-Stehwelle und die dritte Mode der akustischen Biege-Stehwelle erzeugt bzw. angeregt werden.

Die Spannungen U1 und U2 liegen an den Elektroden 18 und 19 des ersten Generators 17 bzw. an den Elektroden 23 und 24 der zweiten Generatoren 22 an.

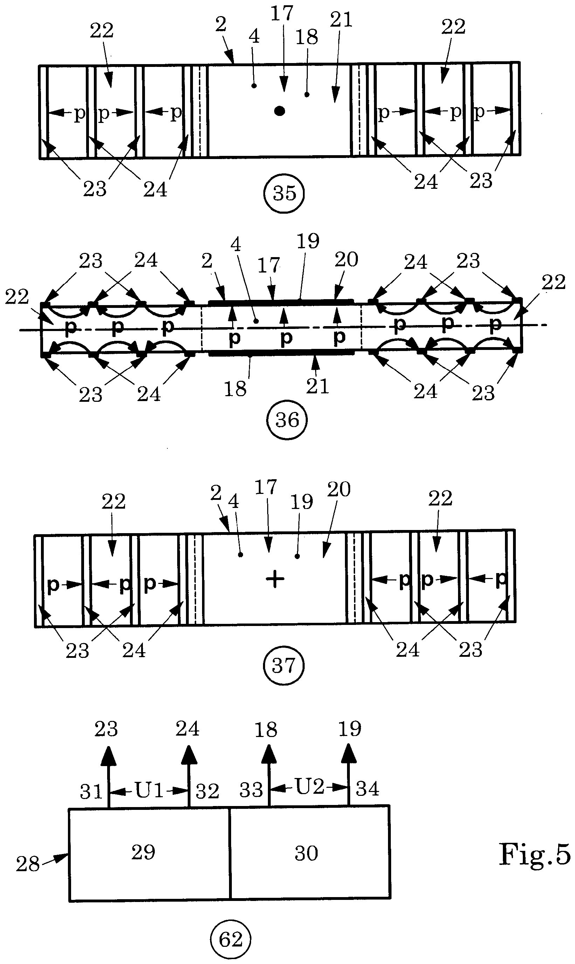

Die Darstellungen 35 bis 37 von Fig. 5 verdeutlichen anhand unterschiedlicher Ansichten die Polarisation des piezoelektrischen Materials eines Ultraschallaktors eines erfindungsgemäßen Ultraschallaktors. Darstellung 35 zeigt dabei den Ultraschallaktor in Vorderansicht, d.h. mit Blick auf eine der beiden Hauptflächen. Im Gegensatz zur Darstellung 27 des Ultraschallaktor**s** gemäß Fig. 4 sind in der Darstellung 37 der Fig. 5 die Reihenfolge der Erregerelektroden 23 und der allgemeinen Elektroden 24 vertauscht und die Polarisationsvektoren (wiederum gekennzeichnet durch Pfeile mit Index p) des piezoelektrischen Materials im Bereich der zweiten Generatoren 22 weisen in umgekehrter Richtung, von den Erregerelektroden 23 in Richtung der allgemeinen Elektroden 24.
In Darstellung 36, einer Draufsicht auf den Ultraschallaktor bzw. auf eine seiner längeren Seitenfläche, ist zu erkennen, dass die Polarisationsvektoren auch hier in einem Bogen von den Erregerelektroden 23 in Richtung der allgemeinen Elektroden 24 weisen, wobei der Pfeil mit dem Index p hier die Gesamtheit der einzelnen geraden Polarisationsvektoren verkörpert. Die einzelnen geraden Polarisationsvektoren ändern dabei, ausgehend von den Erregerelektroden, stetig ihre Richtung. Demgegenüber verlaufen die Polarisationsvektoren des piezoelektrischen Materials im Bereich des ersten Generators 17 in gleichbleibender Richtung von der Erregerelektrode 18 zur allgemeinen Elektrode 19. Darstellung 37 von Fig. 5 zeigt die Rückansicht des Ultraschallaktors gemäß den Darstellungen 35 und 36.

Darstellung 62 von Fig. 5 zeigt eine elektrische Erregervorrichtung 28 und eine Schaltungsanordnung zur elektrischen Ansteuerung des Ultraschallaktors gemäß den Darstellungen 35 bis 37. Die elektrische Erregervorrichtung 28 ist hierbei zweiphasig ausgeführt, und weist zwei Erregervorrichtungsgeneratoren 29 und 30 auf, die an ihren Anschlüssen 31 und 32 bzw. 33 und 34 die elektrischen Wechselspannungen U1 und U2 bereitstellen, die zueinander um den Winkel φ phasenverschoben sind.

Die Spannungen U1 und U2 besitzen die gleiche oder annähernd gleiche Frequenz fo, bei der im Wellenleiter-Resonator 2 die erste Mode der akustischen Längs-Stehwelle und die dritte Mode der akustischen Biege-Stehwelle erzeugt bzw. angeregt werden.

Die Spannungen U1 und U2 liegen an den Elektroden 18 und 19 des ersten Generators 17 bzw. an den Elektroden 23 und 24 der zweiten Generatoren 22 an.

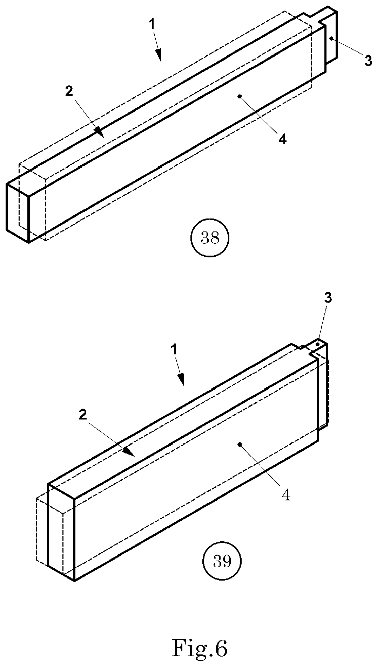

Aufgrund des umgekehrten Piezoeffekts hat das Anlegen der elektrischen Spannung U2 an die Elektroden 18 und 19 des ersten Generators 17 zur Folge, dass die Platte 4 periodisch gedehnt (siehe Darstellung 38 von Fig. 6) und komprimiert (siehe Darstellung 39 von Fig. 6) wird und dadurch die erste Mode einer akustischen Längs-Stehwelle erzeugt wird, die sich entlang der Länge L ausbreitet. Die gestrichelten Linien in den Darstellungen 38 und 39 von Fig. 6 beschreiben hierbei die Ausgangsgeometrie des Ultraschallaktors. Das Dehnen und Komprimieren der Platte 4 wird dabei durch den Piezomodul d31 bewirkt.

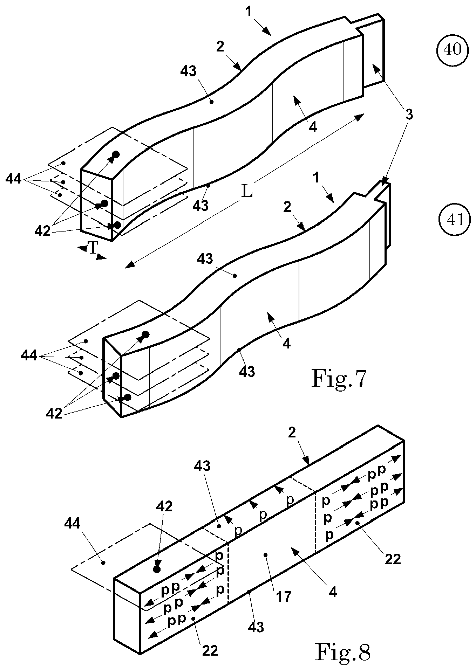

Durch das Anlegen der elektrischen Spannung U1 an die Elektroden 23 und 24 der zweiten Generatoren 22 biegt sich die Platte 4 periodisch in die eine (siehe Darstellung 40 von Fig. 7) und die andere (siehe Darstellung 41 von Fig. 7) Richtung, wobei die dritte Mode einer akustischen Biege-Stehwelle erzeugt wird, die sich entlang der Länge L und der Dicke T ausbreitet. Dabei führt jeder Punkt 42 der Platte 4 Schwingungen in den zu den seitlichen Flächen 43 parallelen Flächen 44 aus, wobei jede der Ebenen 44 als Schwingungsebene der akustischen Biege-Stehwelle für die betrachtete Schwingungsmode betrachtet werden kann. Das Biegen der Platte 4 ist die Folge der unterschiedlich gerichteten Deformation in den Schichten des piezoelektrischen Materials der zweiten Generatoren, die sich nahe den Hauptflächen 20 und 21 befinden. Die Biege-Stehwelle bzw. die entsprechenden Biege-Deformationen der Platte 4 ist das Ergebnis des umgekehrten Piezoeffekts, der durch den Piezomodul d33 bedingt ist. Für die Piezokeramik PIC 181 der Firma PI Ceramic beträgt der Wert des Piezomoduls d33 253 pm/V.

Bei den Ultraschallaktoren für einen erfindungsgemäßen Ultraschallmotor sind die zweiten Generatoren 22 für die akustische Biege-Stehwelle und der erste Generator 17 für die akustische Längs-Stehwelle des Ultraschallaktors 1 so ausgeführt, dass die Richtung der Polarisationsvektoren p des piezoelektrischen Materials des Ultraschallaktors aller Generatoren parallel zu den Schwingungsebenen 44 der akustischen Biege-Stehwelle angeordnet sind, wie dies in Fig. 8 dargestellt ist.

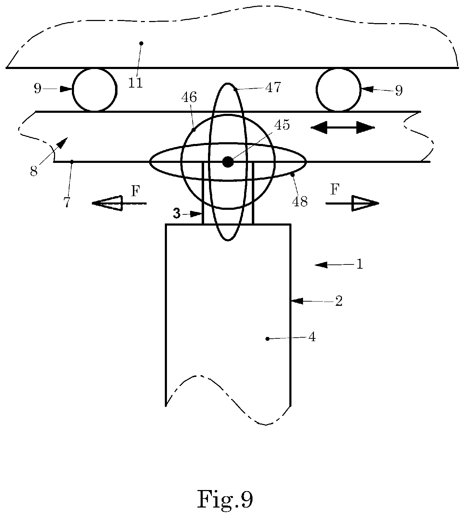

Bei gleichzeitiger Erregung des ersten Generators 17 und der zweiten Generatoren 22 summieren sich die Deformationen der zwei unterschiedlichen, sich im Ultraschallaktor ausbreitenden Typen akustischer Stehwellen, wodurch sich das Friktionselement 3 bzw. der auf diesem angeordnete Punkt 45 auf kreisförmigen Bewegungsbahnen 46 oder auf elliptischen Bewegungsbahnen 47, 48 in der einen oder anderen Richtung bewegen (siehe Fig. 9).

Die Form der Bewegungsbahnen 46, 47, 48 und die Bewegungsrichtung des Friktionselementes 3 wird zum Einen beeinflusst bzw. gesteuert über das Verhältnis der Spannungsamplituden U1 und U2, und zum Anderen vom Phasenverschiebungswinkel φ zwischen den Spannungen U1 und U2.

Aufgrund der Reibung, die zwischen dem Friktionselement 3 und der Friktionsschicht 7 des anzutreibenden Elements 8 bzw. 12 besteht, überträgt der Ultraschallaktor bzw. das an diesem angeordnete Friktionselement die Bewegung bzw. eine entsprechende Kraft F an das anzutreibende Element und versetzt dieses dadurch in Bewegung. Die Kraft F entsteht auf Grund der Biegedeformation der Platte 4, d. h. aufgrund der Ausnutzung des Piezomoduls d33.

Durch Änderung des Phasenverschiebungswinkels φ kann die Bewegungsrichtung des anzutreibenden Elements umgekehrt werden.

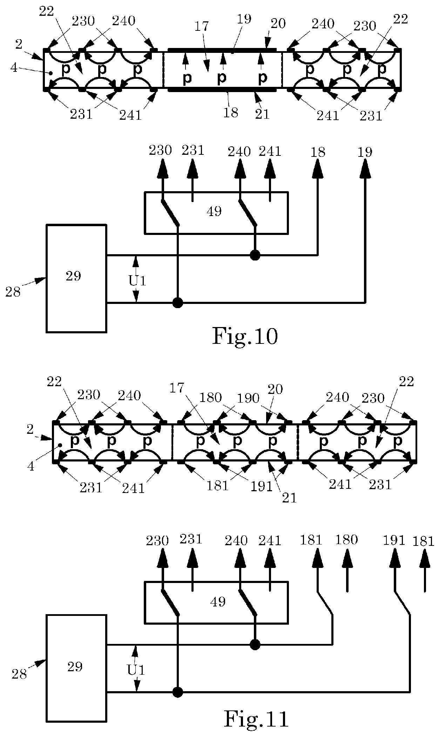

Fig. 10 zeigt eine Schaltungsanordnung zur elektrischen Ansteuerung des Ultraschallaktors gemäß Fig. 5 mit einer einphasigen elektrischen Erregervorrichtung 28, welche einen elektrischen Generator 29, der die elektrische Wechselspannung U1 bereitstellt, umfasst.

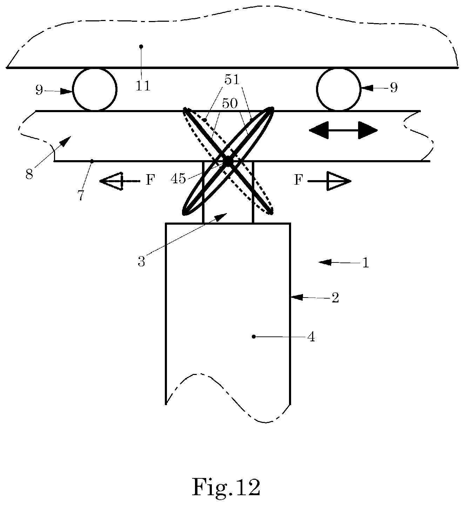

Die Spannung U1 liegt an den Elektroden 18 und 19 des ersten Generators 17 und über den Umschalter 49 an den auf der Hauptfläche 20 angeordneten Erregerelektroden 230 und den allgemeinen Elektroden 240 der zweiten Generatoren 22 an. Bei einer solchen Beschaltung erfolgt eine einseitige asymmetrische Erregung der zweiten Generatoren 22, bei dem die Bahnen der Bewegung des Friktionselementes 3 eine gerade Linie 50 oder eine gedehnte Ellipse 51 darstellen, wie in Fig. 12 gezeigt.

Durch die Bewegung des Friktionselementes auf einer linearen Bewegungsbahn 50 oder auf einer elliptischen Bewegungsbahn 51 überträgt der Ultraschallaktor 1 eine Kraft F an das anzutreibende Element 3, wodurch dieses in Bewegung versetzt wird. In diesem wie auch im vorhergehenden Fall wird die Kraft F durch den Piezomodul d33 bestimmt.

Durch Betätigen des Umschalters 49 erfolgt ein Anlegen der Spannung U1 an die auf der Hauptfläche 21 der Platte 4 angeordneten Erregerelektroden 231 und die allgemeinen Elektroden 241. Dadurch ändert sich der Neigungswinkel der linearen Bewegungsbahn 50 oder der elliptischen Bewegungsbahn 51, wie in Fig. 12 durch die punktierte Linie dargestellt. Durch die Änderung der Neigung der linearen Bewegungsbahn 50 oder 51 kehrt sich die Bewegungsrichtung des anzutreibenden Elements 8 bzw. 12 um.

Fig. 11 zeigt eine Schaltungsanordnung zur elektrischen Ansteuerung des Ultraschallaktors eines erfindungsgemäßen Ultraschallmotors, bei welchem nicht nur die zweiten Generatoren 22 streifenförmige Elektroden aufweisen, sondern auch der erste Generator 17. Der erste Generator 17 weist hierbei Erregerelektroden 180 und 181, und allgemeine Elektroden 190 und 191 auf, welche in ähnlicher oder gleicher Weise wie die streifenförmigen Erregerelektroden und allgemeinen Elektroden der zweiten Generatoren 22 angeordnet sind.

Diese Schaltungsanordnung erlaubt eine asymmetrische Erregung des ersten Generators 17. Dabei wird zur Erzeugung der Längsdeformationen und der Biegedeformationen der Piezomodul d33 eingesetzt.

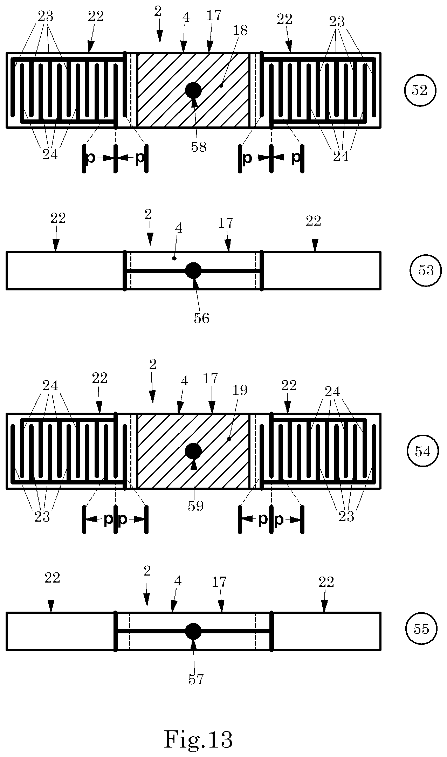

Fig. 13 zeigt in den Darstellungen 52 bis 55 unterschiedliche Ansichten eines Ultraschallaktors eines erfindungsgemäßen Ultraschallmotors. Dabei zeigt Darstellung 52 die entsprechende Vorderansicht, d.h. mit Blick auf eine erste Hauptfläche, während Darstellung 54 die entsprechende Rückansicht, d.h. mit Blick auf die zweite, gegenüberliegende Hauptfläche. Die beiden Darstellungen 53 und 55 zeigen Seitenansichten mit Blick auf die gegenüberliegenden längeren Seitenflächen.

Der Ultraschallaktor weist hierbei Strukturelektroden auf, die beispielsweise im Siebdruckverfahren hergestellt werden können. Hierbei werden über Kontaktflächen 56 und 57 bzw. 58 und 59 die Elektroden der Generatoren 17 und 22 mit der elektrischen Erregervorrichtung 28 verbunden.

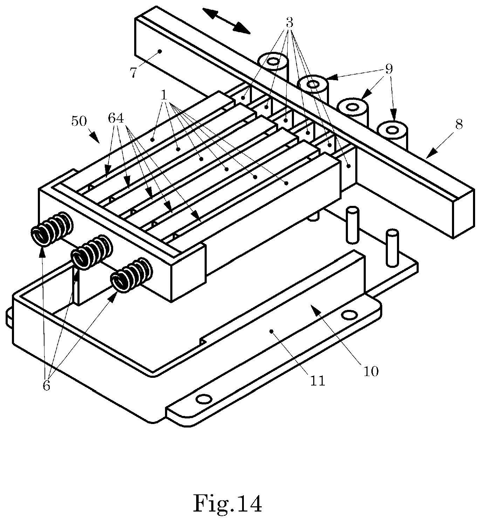

Fig. 14 zeigt eine Ausführungsform des erfindungsgemäßen Ultraschallmotors mit einer Vielzahl von Ultraschallaktoren 1, die zu einem Paket 50 zusammengefasst sind. Jeweils zwischen zwei benachbarten Ultraschallaktoren 1 sind schalldämmenden Schichten 64 angeordnet, die eine akustische Kopplung zwischen den benachbarten Ultraschallaktoren 1 unterbinden. Die Friktionselemente 3, die an den dem anzutreibenden Element zugewandten Stirnflächen der Ultraschallaktoren angeordnet sind, sind mittels der Feder 6 elastisch an die Friktionsschicht 7 des anzutreibenden Elements 8 gepresst.

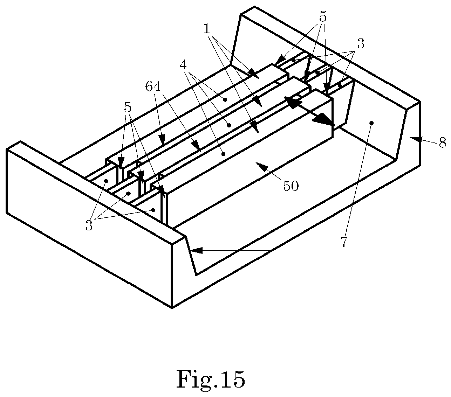

Fig. 15 zeigt eine weitere Ausführungsform des erfindungsgemäßen Ultraschallmotors, der ebenfalls mehrere Ultraschallaktoren aufweist. Hierbei umfasst jeder der Ultraschallaktoren zwei Friktionselemente 3, die an den beiden gegenüberliegenden Stirnflächen 5 angeordnet sind, und die beidseitig elastisch an die Friktionsschichten 7 des anzutreibenden Elements 8 angepresst sind. Die einzelnen Ultraschallaktoren sind hierbei durch dazwischen befindliche schalldämmende Schichten 64 voneinander getrennt.

Die Erfindung ermöglicht Ultraschallmotoren, bei welchen zur Erzeugung der Biegedeformationen statt des Piezomoduls d31 der Piezomodul d33 zur Anwendung kommt. Im Vergleich zu den aus dem Stand der Technik bekannten Ultraschallmotoren ist es dadurch möglich, sowohl die maximale Bewegungsgeschwindigkeit des anzutreibenden Elements, als auch die maximale durch die entsprechenden Ultraschallmotoren entwickelte Kraft um das 2- bis 2,5-fache zu erhöhen, oder in Analogie die elektrische Erregerspannung um das 2- bis 2,5-fache zu verringern.

## Patentansprüche

1. Ultraschallmotor, umfassend einen Wellenleiter-Resonator in Form eines Ultraschallaktors (1) aus einem polarisierten piezoelektrischen Material, zumindest ein an dem Ultraschallaktor angeordnetes Friktionselement (3), ein durch das Friktionselement anzutreibendes Element (8, 12) und eine elektrische Erregervorrichtung (28), wobei der Ultraschallaktor eine plattenförmige Geometrie mit einer Länge L, einer Höhe H, einer Dicke T, zwei flächenmäßig größten Hauptflächen (20, 21), zwei längeren Seitenflächen und zwei kürzeren Seitenflächen, welche Stirnflächen (5) bilden, aufweist und Generatoren (17, 22) für akustische Ultraschallstehwellen umfasst, welche jeweils gebildet sind aus dem piezoelektrischen Material und zumindest einer daran angeordneten Erregerelektrode (18, 23, 180, 181, 230, 231) und wenigstens einer daran angeordneten allgemeinen Elektrode (19, 24, 190, 191, 240, 241), und der Ultraschallaktor in Richtung seiner Länge L in drei Generatorabschnitte unterteilt ist, wobei der zentrale Generatorabschnitt einen ersten Generator (17) zur Erzeugung einer akustischen Längs-Stehwelle aufweist und die beiden peripheren Generatorabschnitte, die beidseitig an den zentralen Generatorabschnitt angrenzen, jeweils einen zweiten Generator (22) zur Erzeugung einer akustischen Biege-Stehwelle aufweisen, wobei wenigstens jeder zweite Generator Erregerelektroden (23, 230, 231) und allgemeine Elektroden (24, 240, 241) in Form dünner Streifen umfasst, die auf den beiden Hauptflächen des Ultraschallaktors in abwechselnder Reihenfolge und in Längenrichtung gesehen jeweils beabstandet und parallel zueinander angeordnet sind und in Richtung der Höhe H des Ultraschallaktors verlaufen, und das piezoelektrische Material der zweiten Generatoren derart polarisiert ist, dass die Polarisationsvektoren parallel zur Schwingungsebene der akustischen Biege-Stehwelle ausgerichtet sind, so dass zur Erzeugung der akustischen Biege-Stehwelle der d33-Piezomodul nutzbar ist, **dadurch gekennzeichnet, dass** die Erregerelektroden (23, 230, 231) und die allgemeinen Elektroden (24, 240, 241) der zweiten Generatoren (22) in Richtung der Höhe H des Ultraschallaktors (1), senkrecht zu der Längserstreckung L des Ultraschallaktors (1) verlaufen.

2. Ultraschallmotor nach Anspruch 1, **dadurch gekennzeichnet, dass** die Polarisationsvektoren des piezokeramischen Materials des ersten Generators ebenfalls parallel zur Schwingungsebene der akustischen Biege Stehwelle ausgerichtet sind und in gleichbleibender Richtung verlaufen, und die Polarisationsvektoren des piezokeramischen Materials der zweiten Generatoren in einem Bogen in stetig ändernder Richtung verlaufen.

3. Ultraschallmotor nach Anspruch 1, **dadurch gekennzeichnet, dass** der erste Generator (17) Erregerelektroden (180, 181) und allgemeine Elektroden (190, 191) in Form dünner Streifen umfasst, die auf den beiden Hauptflächen des Ultraschallaktors in abwechselnder Reihenfolge und jeweils beabstandet und parallel zueinander angeordnet sind.

4. Ultraschallmotor nach einem der vorhergehenden Ansprüche, **dadurch gekennzeichnet, dass** das Verhältnis von Länge L zu Höhe H des Ultraschallaktors so gewählt ist, dass im Ultraschallaktor die erste Mode der akustischen Längs-Stehwelle und die dritte Mode der akustischen BiegeStehwelle anregbar sind, und dass insbesondere L > 3 H ist.

5. Ultraschallmotor nach einem der vorhergehenden Ansprüche, **dadurch gekennzeichnet, dass** das Verhältnis Länge L zu Dicke T des Ultraschallaktors so gewählt ist, dass L gleich der halben Wellenlänge (λ/2) der in dem Ultraschallaktor erzeugten akustischen Längs-Stehwelle und L gleich der anderthalbfachen Wellenlänge (3λ/2) der akustischen Biege-Stehwelle gleicher Frequenz fo entspricht.

6. Ultraschallmotor nach einem der vorhergehenden Ansprüche, **dadurch gekennzeichnet, dass** die Breite der streifenförmigen Erregerelektroden (23, 180, 181, 230, 231) und der streifenförmigen allgemeinen Elektroden (24, 190, 191, 240, 241) kleiner oder gleich 0,1 mm ist.

7. Ultraschallmotor nach einem der vorhergehenden Ansprüche, **dadurch gekennzeichnet, dass** der Abstand zwischen benachbarten streifenförmigen Elektroden kleiner oder gleich T/2 ist.

8. Ultraschallmotor nach einem der vorhergehenden Ansprüche, **dadurch gekennzeichnet, dass** das Friktionselement auf einer der beiden Stirnflächen (5) des Ultraschallaktors angeordnet ist und elastisch an eine Friktionsoberfläche (7) des anzutreibenden Elements angepresst ist.

9. Ultraschallmotor nach einem der Ansprüche 1 bis 7, **dadurch gekennzeichnet, dass** dieser zwei an dem Ultraschallaktor angeordnete Friktionselemente (3) aufweist, wovon ein Friktionselement an einer Stirnfläche des Ultraschallaktors angeordnet ist, und ein Friktionselement an der anderen Stirnfläche des Ultraschallaktors angeordnet ist, und beide Friktionselemente elastisch an Friktionsoberflächen (7) des anzutreibenden Elements angepresst sind.

10. Ultraschallmotor nach einem der vorhergehenden Ansprüche, **dadurch gekennzeichnet, dass** dieser zwei oder mehr Ultraschallaktoren umfasst, wobei zwischen zwei benachbarten Ultraschallaktoren eine schalldämmende Schicht (64) vorgesehen ist.

## Claims

1. An ultrasonic motor comprising a waveguide resonator in the form of an ultrasonic actuator (1) consisting of a polarized piezoelectric material, at least one friction element (3) arranged on the ultrasonic actuator, an element (8, 12) to be driven by the friction element, and an electric excitation device (28), wherein the ultrasonic actuator has a plate-shaped geometry with a length L, a height H and a thickness T, two main faces (20, 21) which are largest in area, two longer side faces and two shorter side faces, the latter defining end faces (5), and comprises generators (17, 22) for acoustic ultrasonic standing waves, each of said generators being defined by the piezoelectric material having at least one excitation electrode (18, 23, 180, 181, 230, 231) arranged thereon and at least one general electrode (19, 24, 190, 191, 240, 241) arranged thereon, and the ultrasonic actuator is divided into three generator segments in the direction of its length L, wherein the central generator segment comprises a first generator (17) for generating a longitudinal acoustic standing wave, and the two peripheral generator segments, which adjoin the central generator segment on both sides, each comprise a second generator (22) for generating a flexural acoustic standing wave, wherein at least each second generator comprises excitation electrodes (23, 230, 231) and general electrodes (24, 240, 241) in the form of thin strips, which are arranged on the two main faces of the ultrasonic actuator in alternate sequence and, when seen in the longitudinal direction, are spaced apart from one another and parallel to one another and which extend in the direction of the height H of the ultrasonic actuator, and that the piezoelectric material of the second generators is polarized such that the polarization vectors are oriented parallel to the oscillation plane of the flexural acoustic standing wave so that the d33 piezo-module can be used for generating the flexural acoustic standing wave, **characterized in that** the excitation electrodes (23, 230, 231) and the general electrodes (24, 240, 241) of the second generators (22) extend in the direction of the height H of the ultrasonic actuator (1), perpendicular to the longitudinal dimensions L of the ultrasonic motor (1).

2. The ultrasonic motor according to claim 1, **characterized in that** the polarization vectors of the piezoceramic material of the first generator are also oriented parallel to the oscillation plane of the flexural acoustic standing wave and run in an unchanging direction, and the polarization vectors of the piezoceramic material of the second generators run in a curve in a continuously changing direction.

3. The ultrasonic motor according to claim 1, **characterized in that** the first generator (17) comprises excitation electrodes (180, 181) and general electrodes (190, 191) in the form of thin strips, which are arranged on the two main faces of the ultrasonic actuator in alternate sequence and in spaced-apart, parallel relationship with one another.

4. The ultrasonic motor according to one of the preceding claims, **characterized in that** the ratio of the length L to the height H of the ultrasonic actuator is chosen such that the first mode of the longitudinal acoustic standing wave and the third mode of the flexural acoustic standing wave can be excited in the ultrasonic actuator, and that in particular L > 3 H.

5. The ultrasonic motor according to one of the preceding claims, **characterized in that** the ratio of the length L to the thickness T of the ultrasonic actuator is chosen such that L is equal to half the wavelength (λ/2) of the longitudinal acoustic standing wave generated in the ultrasonic actuator and L is equal to one and a half times the wavelength (3λ/2) of the flexural acoustic standing wave of the same frequency fo.

6. The ultrasonic motor according to one of the preceding claims, **characterized in that** the width of the stripshaped excitation electrodes (23, 180, 181, 230, 231) and of the stripshaped general electrodes (24, 190, 191, 240, 241) is smaller than or equal to 0.1 mm.

7. The ultrasonic motor according to one of the preceding claims, **characterized in that** the distance between neighboring stripshaped electrodes is smaller than or equal to T/2.

8. The ultrasonic motor according to one of the preceding claims, **characterized in that** the friction element is arranged on one of the two end faces (5) of the ultrasonic actuator and is elastically pressed against a friction surface (7) of the element to be driven.

9. The ultrasonic motor according to one of the claims 1 to 7, **characterized in that** it comprises two friction elements (3) arranged on the ultrasonic actuator, one of said friction elements being arranged on one end face of the ultrasonic actuator and the other friction element being arranged on the other end face of the ultrasonic actuator, and both friction elements being elastically pressed against friction surfaces (7) of the element to be driven.

10. The ultrasonic motor according to one of the preceding claims, **characterized in that** it comprises two or more ultrasonic actuators, a sound-absorbing layer (64) being provided between two neighboring ultrasonic actuators.

## Revendications

1. Moteur ultrasonique, comprenant un résonateur-guide d'ondes sous la forme d'un actionneur ultrasonique (1) en un matériau piézoélectrique polarisé, au moins un élément de friction (3) agencé sur l'actionneur ultrasonique, un élément (8, 12) à entraîner par l'élément de friction, et un dispositif d'excitation électrique (28), moteur ultrasonique
dans lequel l'actionneur ultrasonique présente une géométrie en forme de plaque avec une longueur L, une hauteur H, une épaisseur T, deux surfaces principales (20, 21) les plus grandes en surface, deux surfaces latérales plus longues et deux surfaces latérales plus courtes, qui forment des surfaces frontales (5), et comprend des générateurs (17, 22) pour ondes acoustiques ultrasonores, qui sont réalisés respectivement en ledit matériau piézoélectrique et par au moins une électrode d'excitation (18, 23, 180, 181, 230, 231), qui y est agencée, et par au moins une électrode générale (19, 24, 190, 191, 240, 241), qui y est agencée, et l'actionneur ultrasonique est subdivisé dans la direction de sa longueur L, en trois tronçons de générateur,
dans lequel le tronçon de générateur central présente un premier générateur (17) pour produire une onde acoustique stationnaire longitudinale, et les deux générateurs périphériques, qui sont adjacents de part et d'autre au tronçon de générateur central, présentent respectivement un deuxième générateur (22) pour produire d'une onde acoustique stationnaire de flexion, et
dans lequel au moins chaque deuxième générateur comprend des électrodes d'excitation (23, 230, 231) et des électrodes générales (24, 240, 241) sous la forme de bandes fines, qui sont agencées selon un ordre alterné sur les deux surfaces principales et, vu dans la direction de la longueur, de manière mutuellement espacée et parallèlement les unes aux autres, en s'étendant dans la direction de la hauteur H de l'actionneur ultrasonique, et le matériau piézoélectrique des deuxièmes générateurs est polarisé de manière telle, que les vecteurs de polarisation soient orientés parallèlement au plan d'oscillation de l'onde acoustique stationnaire de flexion, de sorte qu'il est possible d'utiliser le module piézoélectrique d33 pour produire l'onde acoustique stationnaire de flexion,
**caractérisé en ce que** les électrodes d'excitation (23, 230, 231) et les électrodes générales (24, 240, 241) des deuxièmes générateurs (22) s'étendent dans la direction de la hauteur H de l'actionneur ultrasonique (1), perpendiculairement à l'étendue en longueur L de l'actionneur ultrasonique (1).

2. Moteur ultrasonique selon la revendication 1, **caractérisé en ce que** les vecteurs de polarisation du matériau piézoélectrique du premier générateur sont également orientés parallèlement au plan d'oscillation de l'onde acoustique stationnaire de flexion et s'étendent selon une direction restant constante, et les vecteurs de polarisation du matériau piézoélectrique des deuxièmes générateurs s'étendent selon un arc avec une direction variant de manière continue.

3. Moteur ultrasonique selon la revendication 1, **caractérisé en ce que** le premier générateur (17) comprend des électrodes d'excitation (180, 181) et des électrodes générales (190, 191) sous la forme de bandes fines, qui sont agencées sur les deux surfaces principales de l'actionneur ultrasonique, selon un ordre alterné et de manière mutuellement espacée et parallèlement les unes aux autres.

4. Moteur ultrasonique selon l'une des revendications précédentes, **caractérisé en ce que** le rapport de la longueur L à la hauteur H de l'actionneur ultrasonique est choisi de manière telle, que dans l'actionneur ultrasonique il soit possible d'exciter le premier mode de l'onde acoustique stationnaire longitudinale et le troisième mode de l'onde acoustique stationnaire de flexion, et que notamment L > 3H.

5. Moteur ultrasonique selon l'une des revendications précédentes, **caractérisé en ce que** le rapport de la longueur L à l'épaisseur T de l'actionneur ultrasonique est choisi de manière telle, que L soit égale à la moitié de la longueur d'onde (λ/2) de l'onde acoustique stationnaire longitudinale produite dans l'actionneur ultrasonique, et que L corresponde à une fois et demie la longueur d'onde (3λ/2) de l'onde acoustique stationnaire de flexion de même fréquence f0.

6. Moteur ultrasonique selon l'une des revendications précédentes, **caractérisé en ce que** la largeur des électrodes d'excitation (23, 180, 181, 230, 231) en forme de bande, et des électrodes générales (24, 190, 191, 240, 241) en forme de bande est inférieure ou égale à 0,1 mm.

7. Moteur ultrasonique selon l'une des revendications précédentes, **caractérisé en ce que** la distance entre des électrodes en forme de bande voisines est inférieure ou égale à T/2.

8. Moteur ultrasonique selon l'une des revendications précédentes, **caractérisé en ce que** l'élément de friction est agencé sur l'une des deux surfaces frontales (5) de l'actionneur ultrasonique, et est pressé élastiquement contre une surface de friction (7) de l'élément à entraîner.

9. Moteur ultrasonique selon l'une des revendications 1 à 7, **caractérisé en ce que** celui-ci présente deux éléments de friction (3) agencés sur l'actionneur ultrasonique, dont un élément de friction est agencé sur une surface frontale de l'actionneur ultrasonique, et un élément de friction est agencé sur l'autre surface frontale de l'actionneur ultrasonique, et les deux éléments de friction sont pressés élastiquement contre des surfaces de friction (7) de l'élément à entraîner.

10. Moteur ultrasonique selon l'une des revendications précédentes, **caractérisé en ce que** celui-ci comprend deux actionneurs ultrasoniques ou davantage, une couche d'amortissement acoustique (64) étant prévue entre deux actionneurs ultrasoniques voisins.
